# FASCICULE DE BREVET EUROPEEN

(11) **EP 2 053 741 B1**
(45) Date de publication et mention de la délivrance du brevet: **07.07.2010**
(21) Numéro de dépôt: 08354065.8
(22) Date de dépôt: 30.09.2008
(51) Int. Cl.: H03K 17/082, H03K 19/007

(54) **Dispositif de commutation électrique statique auto-protégé**
Selbstschützende elektrische Schaltvorrichtung
Self-protected static electric switching device

(30) Priorité: 26.10.2007 FR 0707548
(43) Date de publication de la demande: 29.04.2009
(73) Titulaire: Crouzet Automatismes, 26000 Valence (FR)
(72) Inventeur: Girot, Dominique, 38050 Grenoble Cedex 09 (FR); Carton, Hervé, 38050 Grenoble Cedex 09 (FR)
(74) Mandataire: Tripodi, Paul

(56) Documents cités:
- WO-A-02/095895
- JP-A- 9 288 138
- JP-A- 2002 095 153

## Description

### DOMAINE TECHNIQUE DE L'INVENTION

L'invention est relative à un dispositif de commutation statique auto protégé comportant un premier moyen d'ouverture connecté en série avec un premier élément fusible, des moyens mesure de courant électrique et des moyens de commande agissant sur l'ouverture et la fermeture dudit premier moyen d'ouverture en fonction de la valeur d'un courant électrique principal (i) traversant ledit dispositif de commutation.

### ETAT DE LA TECHNIQUE ANTERIEURE

Les composants de puissance utilisés pour assurer la fonction de commutation électrique sont largement employés notamment dans le domaine aéronautique. A titre d'exemple, ces composants peuvent être des transistors de type MOSFET, IGBT, BIPOLAIRES ou ESBT^{™}. Les dispositifs de commutation utilisés comme disjoncteur statique sont appelé par la suite SSPC (Solid State Power Controler) ou CDS (Contacteur Disjoncteur Statique).

Le principal mode de défaillance des moyens de commutation des SSPC provient du fait qu'ils peuvent se trouver en court-circuit après leur destruction. Chaque commutateur de puissance, bien que protégé contre des causes de destructions dues à un échauffement, à une surtension ou à des variations brutales de tension, peut être cependant fortement endommagé et se placer dans un état de court-circuit.

Depuis la généralisation de l'utilisation des SSPC dans les avions gros porteurs civils, les autorités de certification ont exigé que les SSPC intègre un second niveau de protection. Pour sécuriser l'installation en cas de détérioration d'un commutateur de puissance d'un SSPC, il est en effet prévu d'insérer un second dispositif d'ouverture du circuit. Ce second dispositif d'ouverture est placé en série avec le commutateur de puissance du SSPC. Ce second dispositif d'ouverture s'ouvrira en cas de sur-consommation électrique, notamment en cas de court-circuit. Ainsi, l'ensemble constitué du commutateur de puissance et du second dispositif d'ouverture est ainsi autoprotégé. Cette autoprotection est appelée par la suite "Fail Safe".

Un exemple pour un tel dispositif est donné dans le document JP 2002 095153 A.

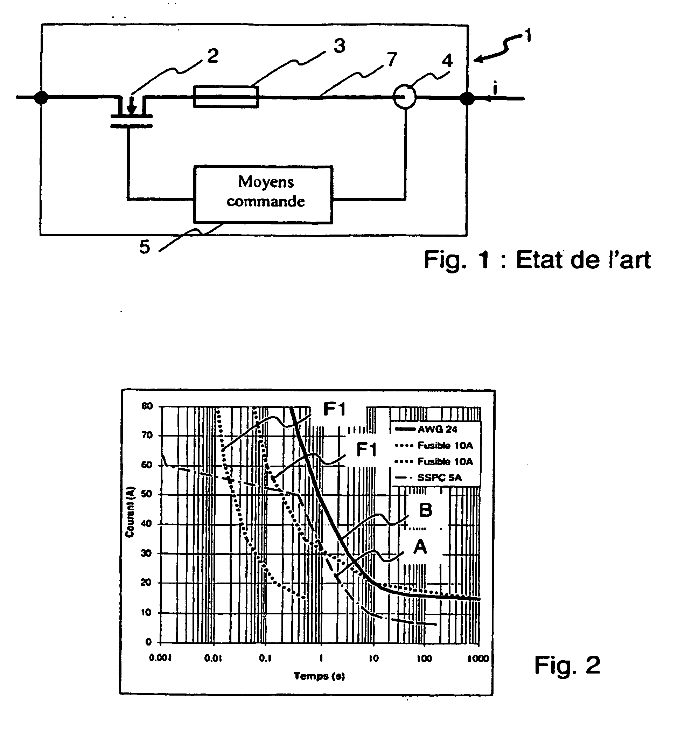

Comme représenté sur la figure 1, il est connu d'utiliser un fusible 3 comme second dispositif d'ouverture. Le fusible 3 est placé en série avec le commutateur de puissance 3 du SSPC 1. Cependant, l'utilisation d'un fusible 3 n'est pas toujours judicieuse, à cause d'une trop grande incertitude relative à la valeur de l'intensité nominale dudit fusible. Le fusible 3 atteint théoriquement son seuil de fusion lorsqu'il est traversé par des courants électriques ayant des valeurs d'intensité supérieures à la valeur d'intensité nominale On entend par valeur d'intensité nominale, la valeur fournie par le constructeur du fusible. En réalité, le seuil de fusion peut être atteint pour des valeurs de courant électrique légèrement supérieures ou légèrement inférieures.

Compte tenu de la dispersion des caractéristiques d'un fusible autour de sa valeur d'intensité nominale, il peut être établi deux courbes de fusion. Un première courbe, dite min, représente le point de fusion du fusible pour les plus faibles valeurs de courant. Une seconde courbe, dite max, représente le point de fusion du fusible pour les fortes valeurs de courant.

Comme schématisé sur la figure 2, la courbe A représente le temps d'ouverture d'un commutateur de puissance en fonction d'un courant électrique le traversant. Selon ce mode de réalisation, le SSPC est destiné à protéger un câblé contre des courants d'intensité supérieure à cinq ampères. A titre d'exemple, le câble comporte la référence suivante : Gauge AWG 24. La courbe B représente la courbe de fumée dudit câble. Les courbes F1 représentent les courbes de fusion min et max d'un fusible de protection de calibre 10 ampères placé en série avec le commutateur de puissance du SSPC.

En fonctionnement normal, le SSPC doit pouvoir être réarmé après avoir disjoncté et le fusible doit, de préférence, ne pas fondre avant que le commutateur de puissance du SSPC ne s'ouvre. En outre, afin de s'assurer que le fusible ne fonde pas après le câble, la courbe de fusion max doit être choisie afin d'être en dessous de la courbe de fumée du câble.

Compte tenu des dispersions des caractéristiques du fusible, Il est très difficile d'obtenir un fusible répondant à ces deux conditions de fonctionnement. Une première condition de fonctionnement consiste à utiliser un fusible dont la courbe de fusion max soit en dessous de la courbe de fumée du câble. La seconde condition de fonctionnement consiste à utiliser un fusible dont la courbe de fusion min ne soit pas inférieure à la courbe de déclenchement du commutateur de puissance du SSPC.

Si la seconde condition de fonctionnement n'est pas respectée, le fusible risque de fondre avant que le SSPC ne disjoncte. Dans ces circonstances, le changement du second dispositif d'ouverture, autrement dit le fusible, entraîne des immobilisations des avions. Ces immobilisations auraient pu être évitées si la fonction disjoncteur avait fonctionnée avant le fusible. En effet un simple réarmement à distance du SSPC après suppression du défaut aurait été suffisant.

### EXPOSE DE L'INVENTION

L'invention vise donc à remédier aux inconvénients de l'état de la technique, de manière à proposer un dispositif de commutation statique auto protégé ayant un fonctionnement fiable.

Le dispositif de commutation statique auto protégé selon l'invention comporte au moins un second élément fusible connecté en parallèle avec le premier un élément fusible, au moins un second moyen d'ouverture électrique étant connecté en série avec ledit au moins second élément fusible.

Selon un mode préférentiel de réalisation de l'invention, ledit au moins un second moyen d'ouverture connecté audit au moins un second élément fusible sont connectés en parallèle avec le premier élément fusible.

Selon un autre mode préférentiel de réalisation de l'invention, ledit au moins un second moyen d'ouverture connecté audit au moins un second élément fusible sont connectés en parallèle avec le premier élément fusible et avec le premier moyen d'ouverture.

Avantageusement, le premier moyen d'ouverture électrique est un commutateur de puissance relié aux moyens de commande d'ouverture et de fermeture.

Avantageusement, ledit au moins un second moyen d'ouverture électrique est un commutateur de puissance relié aux moyens de commande d'ouverture et de fermeture.

De préférence, ledit au moins un second moyen d'ouverture électrique comporte un relais électromagnétique

Selon un mode particulier de réalisation, le relais électromagnétique est commandé par un bilame.

De préférence, le bilame est traversé par le courant électrique principal et est calibré pour se déformer et actionner le relais lorsque le courant principal est supérieur à un premier seuil.

De préférence, le bilame est traversé par un courant électrique secondaire traversant ledit au moins un second élément fusible et est calibré pour se déformer et actionner le relais lorsque le courant secondaire est supérieur à un second seuil.

De préférence, tous les éléments fusibles ont des valeurs d'intensité nominales sensiblement identiques.

### BREVE DESCRIPTION DES FIGURES

D'autres avantages et caractéristiques ressortiront plus clairement de la description qui va suivre de modes particuliers de réalisation de l'invention, donnés à titre d'exemples non limitatifs, et représentés aux dessins annexés sur lesquels :
la figure 1 représente une vue schématique d'un dispositif de commutation électrique statique auto-protégé selon mode de réalisation connu ;
la figure 2 représente une courbe du temps d'ouverture d'un commutateur de puissance d'un dispositif de commutation électrique statique auto-protégé en fonction d'un courant électrique le traversant selon un mode de réalisation représenté à la figure 1 ;
la figure 3 représente une vue schématique d'un dispositif de commutation électrique statique auto-protégé selon un premier mode préférentiel de réalisation de l'invention ;

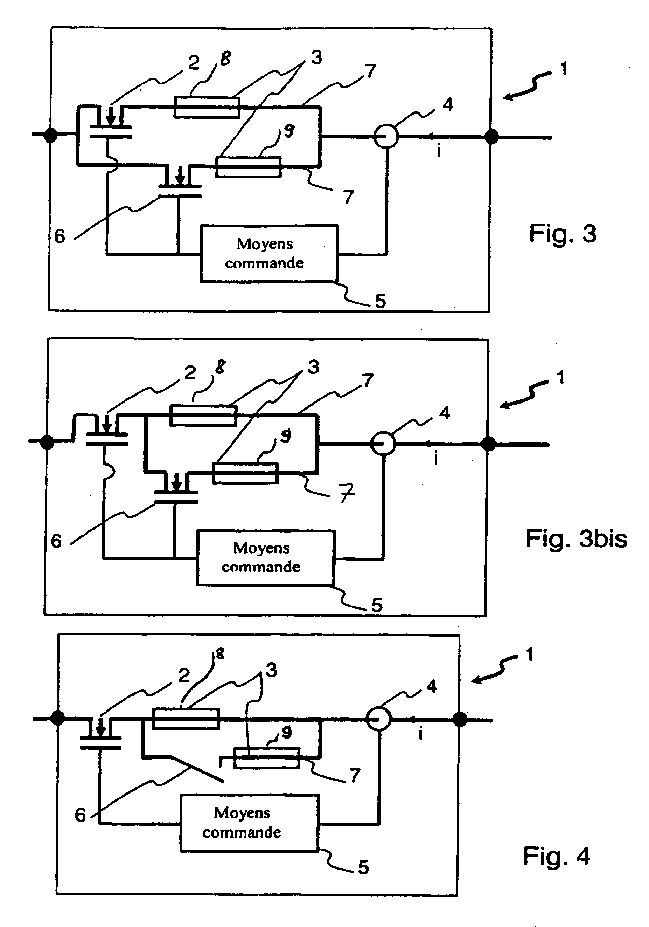

la figures 3bis représente une vue schématique d'un dispositif de commutation électrique statique auto-protégé selon un second mode préférentiel de réalisation de l'invention ;
la figure 4 représente une vue schématique d'un dispositif de commutation électrique statique auto-protégé selon variante du second mode préférentiel de réalisation de l'invention ;

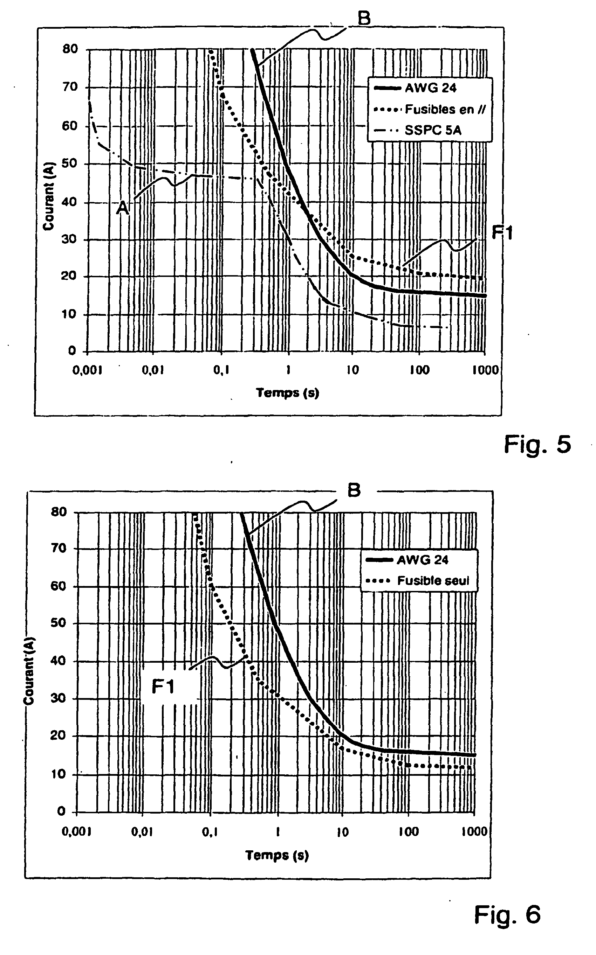

la figure 5 représente une courbe du temps d'ouverture d'un commutateur selon les modes de réalisation représentés aux figures 3 et 4 en mode de fonctionnement normal ;
la figure 6 représente une courbe du temps d'ouverture d'un commutateur selon les modes de réalisation représentés aux figures 3 et 4 en présence d'un défaut de fonctionnement.

### DESCRIPTION DETAILLEE D'UN MODE DE REALISATION

Selon un premier mode préférentiel de réalisation de l'invention représenté sur la figure 3, le dispositif de commutation statique auto protégé 1 comporte au moins deux branches 7 placées en parallèle. Chaque branche 7 comporte au moins un commutateur de puissance 2,6 connecté en série avec un fusible 8,9.

Le dispositif de commutation statique auto protégé 1 comporte un capteur de courant 4 mesurant le courant électrique i traversant ledit dispositif. Ledit courant sera appelé par la suite courant principal i. Le capteur de courant 4 est relié à des moyens de commande 5. Lesdits moyens de commande sont reliés aux commutateurs de puissance 2,6 afin de commander leur ouverture et leur fermeture. Le courant électrique i traversant le dispositif de commutation statique auto protégé 1 se divise dans chaque branche 7 du circuit. Les courants électriques circulant dans les différentes branches 7 du circuit seront appelés par la suite courant secondaire i/n.

Les courants secondaires circulant dans les branches 7 du circuit sont de même intensité. Chaque fusible 3 est alors traversé par un courant électrique secondaire i/n ayant une valeur égale à la valeur du courant électrique principal i divisée par n, n étant égal au nombre de branche 7. Selon les modes de réalisation représentés sur les figures 3 à 4, le nombre de branches 7 est égal à deux (n=2). Les courants secondaires circulant dans les branches de 7 sont égaux et ont pour valeur i/2.

De préférence, les fusibles 3 ont des valeurs d'intensité nominales sensiblement identiques.

Le fonctionnement du dispositif de commutation statique auto protégé 1 selon le premier mode préférentiel de réalisation est le suivant.

Les valeurs d'intensité nominales de chaque fusible 3 sont choisies en fonction du courant secondaire maximal admissible dans chaque branche 7. Selon le premier mode préférentiel de réalisation, le courant secondaire maximal admissible est égal à la valeur du courant principal maximal admissible divisée par le nombre de branches 7. La valeur du courant principal maximal admissible est dépendante du câble qui doit être protégé.

Lorsque tous les commutateurs fonctionnent normalement, chaque commutateur de puissance 2,6 placé en série avec un des fusibles 3 s'ouvre quand le courant principal i mesuré par les capteurs de courant 4 est supérieur au courant principal maximal admissible. La coupure est alors réalisée correctement par le dispositif de commutation statique auto protégé 1. Comme représenté sur la figure 5, la courbe A représente le temps d'ouverture des commutateurs de puissance 2,6 en fonction du courant électrique. Ladite courbe se place en deçà de la courbe F1 représentative de la courbe de fusion des fusibles 3 de protection placés les branches 7 et de la courbe de fumée B du câble à protéger. La courbe F1 est une courbe résultante représentative de la somme des courbes de fusion min des fusibles 3 placés en parallèle. Cette configuration permet de garantir que les fusibles 3 n'atteignent pas leur seuil de fusion avant que les commutateurs de puissance 2,6 s'ouvrent.

Lorsqu'un des commutateurs de puissance 2,6 est endommagé et se place dans un état de court-circuit, le courant électrique secondaire i/n circulant dans la ou les branches 7 non ouvertes est alors supérieur au courant secondaire maximal admissible dans chaque branche 7.

Selon le mode de réalisation représenté sur la figure 3, le courant électrique secondaire circulant dans la branche 7 comportant le commutateur de puissance 2,6 court-circuité est sensiblement égal au courant principal maximal admissible. Le fusible 8,9 placé en série avec le commutateur de puissance 2,6 court-circuité est alors traversé par un courant électrique qui est largement supérieur au courant secondaire maximal admissible. Le seuil de fusion est atteint et ledit fusible fond. La coupure est alors réalisée correctement par le dispositif de commutation statique auto protégé 1. Comme représenté sur la figure 5, la courbe F1 représente la courbe de fusion maxi du fusible de protection 3 placé sur la branche 7 qui est encore traversée par un courant électrique suite à l'envoi de l'ordre d'ouverture des moyens de commande 5. Ladite courbe se place en deçà de la courbe B représentative de la courbe de fumée du câble à protéger. Cette configuration permet de garantir que le fusible 3 atteigne son seuil de fusion avant que le câble à protéger ne soit endommagé.

En outre, le dispositif de commutation statique auto protégé 1 est définitivement ouvert. En effet, si les moyens de commande 5 envoient un ordre de fermeture aux commutateurs de puissance 2,6 bien que le défaut de fonctionnement ne soit pas résolu, le courant électrique secondaire circulant dans les branches 7 serait obligatoirement d'intensité supérieure au courant secondaire maximal admissible dans chaque branche, puisqu'une des branches 7 est définitivement ouverte par son fusible, et entrainerait la fusion du ou des fusible restants.

Selon une variante de réalisation du premier mode préférentiel de réalisation, le dispositif de commutation statique auto protégé 1 comporte trois fusibles. Chacun des fusibles est placé sur une branche 7 de circuit.

Selon un second mode préférentiel de réalisation de l'invention représenté sur la figure 3bis, un second moyen d'ouverture 6 est connecté en série avec un fusible 9 d'une des branches 7. Selon ce mode de réalisation, le dispositif de commutation statique auto protégé 1 comporte deux branches 7 connectées en parallèle. Le second moyen d'ouverture 6 et le second fusible 9 sont connectés en parallèle avec le premier fusible 8.

Les courants secondaires circulant dans les branches 7 du circuit sont de même intensité. Chaque fusible est alors traversé par un courant électrique secondaire i/n ayant une valeur égale à la valeur du courant électrique principal i divisée par n, n étant égal au nombre de branche 7.

Selon le mode de réalisation présenté à la figure 3bis, les courants secondaires circulant dans les branches de 7 ont pour valeur i/2. Chaque fusible 3 est alors calibré pour atteindre son seuil de fusion pour des courants électriques secondaires de valeur égale à la moitié du courant principal maximal admissible. La valeur du courant principal maximal admissible est dépendante du câble qui doit être protégé. Le second moyen d'ouverture 6 est en série avec le fusible 9. Le second moyen d'ouverture 6 est destiné à s'ouvrir quand le courant électrique qui traverse le dispositif de commutation statique auto protégé 1 est supérieur au courant principal maximal admissible.

Le fonctionnement du dispositif de commutation statique auto protégé 1 selon le second mode préférentiel de réalisation est le suivant.

Lorsque le premer commutateur de puissance 2 fonctionne normalement, ce dernier s'ouvre quand le courant principal mesuré par les capteurs de courant 4 est supérieur au courant principal maximal admissible. La coupure est alors réalisée correctement par le dispositif de commutation statique auto protégé 1.

Lorsque le premier commutateur de puissance 2 est endommagé et se place dans un état de court-circuit, les courants électriques secondaires qui circulent dans les branches 7 du circuit sont alors supérieurs au courant secondaire maximal admissible dans chaque branche 7. Le second moyen d'ouverture 6 s'ouvre compte tenu que le courant circulant dans le dispositif de commutation statique auto protégé 1 est supérieur au courant principal maximal admissible, et que le premier commutateur de puissance 2 ne peut plus s'ouvrir.

Après l'ouverture du second moyen d'ouverture 6, le courant électrique circule dans la ou les autres branches 7. Selon le mode de réalisation représenté à la figure 3bis, le courant électrique circule dans l'autre branche 7 et provoque la fusion du fusible présent sur cette branche 7. En effet, ledit fusible est traversé par un courant électrique dont la valeur est égale à la valeur du courant principal.

Ainsi, même si le second moyen d'ouverture 6 présent sur la première branche 7 se referme, le courant électrique provoque la fusion du fusible 9 présent sur la première branche. Le dispositif de commutation statique auto protégé 1 est désormais définitivement ouvert. Cette situation pourrait se produire selon un mode de réalisation particulier de type passif.

De préférence, les fusibles 3 ont des valeurs d'intensité nominale sensiblement identiques.

Comme représenté sur la figure 4, le second moyen d'ouverture 6 peut être passif ou à commande autonome. Lorsque le second moyen d'ouverture 6 est un bilame, le système est entièrement passif, mais est peu précis.

Lorsque le second moyen d'ouverture 6 est un relais commandé par une logique de pilotage du dispositif de commutation statique auto protégé 1, le système est actif et précis. Cependant, ce moyen de protection doit posséder sa propre alimentation électrique. En outre, Afin d'être autonome, sa logique de décision devra être différente de celle des moyens de commande 5. Le second moyen d'ouverture 6 peut être aussi un relais commandé par une fonction de type I2t, indépendante de la fonction SSPC. C'est alors un système actif et précis, et autonome.

## Revendications

1. Dispositif de commutation statique auto protégé (1) comportant un premier moyen d'ouverture (2) connecté en série avec un premier élément fusible (8), des moyens mesure de courant électrique (4) et des moyens de commande (5) agissant sur l'ouverture et la fermeture dudit premier moyen d'ouverture (2) en fonction de la valeur d'un courant électrique principal (i) traversant ledit dispositif de commutation (1), **caractérisé en ce qu'**il comporte au moins un second élément fusible (9) connecté en parallèle avec le premier un élément fusible (8), au moins un second moyen d'ouverture électrique (6) étant connecté en série avec ledit au moins second élément fusible (9).

2. Dispositif de commutation statique auto protégé selon la revendication 1, **caractérisé en ce que** ledit au moins un second moyen d'ouverture (6) connecté audit au moins un second élément fusible (9) sont connectés en parallèle avec le premier élément fusible (8).

3. Dispositif de commutation statique auto protégé selon la revendication 2, **caractérisé en ce que** ledit au moins un second moyen d'ouverture (6) connecté audit au moins un second élément fusible (9) sont connectés en parallèle avec le premier élément fusible (8) et avec le premier moyen d'ouverture (2).

4. Dispositif de commutation statique auto protégé selon l'une des revendications 1 à 3, **caractérisé en ce que** le premier moyen d'ouverture électrique (2) est un commutateur de puissance relié aux moyens de commande (5) d'ouverture et de fermeture.

5. Dispositif de commutation statique auto protégé selon quelconque des revendications précédentes, **caractérisé en ce que** ledit au moins un second moyen d'ouverture électrique (6) est un commutateur de puissance relié aux moyens de commande (5) d'ouverture et de fermeture.

6. Dispositif de commutation statique auto protégé selon quelconque des revendications 1 à 4, **caractérisé en ce que** ledit au moins un second moyen d'ouverture électrique (6) comporte un relais électromagnétique commandé par un bilame.

7. Dispositif de commutation statique auto protégé selon la revendication 6, **caractérisé en ce que** le relais électromagnétique est commandé par un bilame.

8. Dispositif de commutation statique auto protégé selon la revendication 7, **caractérisé en ce que** ledit bilame est traversé par le courant électrique principal (i) et est calibré pour se déformer et actionner le relais lorsque le courant principal (i) est supérieur à un premier seuil.

9. Dispositif de commutation statique auto protégé selon la revendication 7, **caractérisé en ce que** ledit bilame est traversé par un courant électrique secondaire (i/n) traversant ledit au moins un second élément fusible (9) et est calibré pour se déformer et actionner le relais lorsque le courant secondaire (i/n) est supérieur à un second seuil.

10. Dispositif de commutation statique auto protégé selon l'une quelconque des revendications précédentes **caractérisé en ce que** tous les éléments fusibles (3) ont des valeurs d'intensité nominales sensiblement identiques.

## Claims

1. Self-protected solid-state switching device (1) comprising a first opening means (2) connected in series with a first fuse link (8), means for measuring electric current (4) and control means (5) acting on opening and closing of said first opening means (2) according to the value of a main electric current (i) flowing through said switching device (1), **characterized in** it comprises at least a second fuse link (9) connected in parallel with the first fuse link (8), at least a second electric opening means (6) being connected in series with said at least a second fuse link (9).

2. Self-protected solid-state switching device according to claim 1, **characterized in that** said at least a second electric opening means (6) connected to said at least a second fuse link (9) are connected in parallel with the first fuse link (8).

3. Self-protected solid-state switching device according to claim 2, **characterized in that** said at least a second electric opening means (6) connected to said at least a second fuse link (9) are connected in parallel with the first fuse link (8) and with the first opening means (2).

4. Self-protected solid-state switching device according to any one of claims 1 to 3, **characterized in that** the first electric opening means (2) is a power switch connected to the opening and closing control means (5).

5. Self-protected solid-state switching device according to any one of the foregoing claims, **characterized in that** said at least a second electric opening means (6) is a power switch connected to the opening and closing control means (5).

6. Self-protected solid-state switching device according to any one of claims 1 to 4, **characterized in that** said at least a second electric opening means (6) comprises an electromagnetic relay controlled by a bimetal strip.

7. Self-protected solid-state switching device according to claim 6, **characterized in that** the electromagnetic relay is controlled by a bimetal strip.

8. Self-protected solid-state switching device according to claim 7, **characterized in that** the main electric current (i) flows through said bimetal strip that is calibrated to deform and actuate the relay when the main current (i) is greater than a first threshold.

9. Self-protected solid-state switching device according to claim 7, **characterized in that** a secondary electric current (i/n) flowing through said at least a second fuse link (9) flows through said bimetal strip that is calibrated to deform and actuate the relay when the secondary current (i/n) is greater than a second threshold.

10. Self-protected solid-state switching device according to any one of the foregoing claims, **characterized in that** all the fuse links (3) have substantially identical rated intensity values.

## Patentansprüche

1. Fehlersichere statische Umschalteinrichtung (1), die ein erstes, mit einem ersten Schmelzsicherungselement (8) in Reihe geschaltetes Ausschaltmittel (2), Strommessmittel (4) sowie Steuermittel (5) umfasst, die den Ausschalt- und Einschaltvorgang des genannten ersten Ausschaltmittels (2) in Abhängigkeit von dem Wert eines über die genannte Umschalteinrichtung (1) fließenden Hauptstroms (i) steuern, **dadurch gekennzeichnet, dass** die Einrichtung mindestens ein, parallel zum ersten Schmelzsicherungselement (8) geschaltetes zweites Schmelzsicherungselement (9) umfasst, wobei mindestens ein zweites elektrisches Ausschaltmittel (6) mit dem genannten mindestens einfach vorhandenen zweiten Schmelzsicherungselement (9) in Reihe geschaltet ist.

2. Fehlersichere statische Umschalteinrichtung nach Anspruch 1, **dadurch gekennzeichnet, dass** das genannte mindestens einfach vorhandene und mit dem mindestens einfach vorhandenen zweiten Schmelzsicherungselement (9) verbundene zweite Ausschaltmittel (6) parallel zum ersten Schmelzsicherungselement (8) geschaltet ist.

3. Fehlersichere statische Umschalteinrichtung nach Anspruch 2, **dadurch gekennzeichnet, dass** das genannte mindestens einfach vorhandene und mit dem mindestens einfach vorhandenen zweiten Schmelzsicherungselement (9) verbundene, zweite Ausschaltmittel (6) parallel zum ersten Schmelzsicherungselement (8) und zum ersten Ausschaltmittel (2) geschaltet ist.

4. Fehlersichere statische Umschalteinrichtung nach einem der Ansprüche 1 bis 3, **dadurch gekennzeichnet, dass** das erste elektrische Ausschaltmittel (2) als mit den Ausschalt- und Einschalt-Steuermitteln (5) verbundener Leistungsumschalter ausgebildet ist.

5. Fehlersichere statische Umschalteinrichtung nach irgendeinem der vorhergehenden Ansprüche, **dadurch gekennzeichnet, dass** das genannte, mindestens einfach vorhandene zweite elektrische Ausschaltmittel (6) als mit den Ausschalt- und Einschalt-Steuermitteln (5) verbundener Leistungsumschalter ausgebildet ist.

6. Fehlersichere statische Umschalteinrichtung nach irgendeinem der Ansprüche 1 bis 4 **dadurch gekennzeichnet, dass** das genannte, mindestens einfach vorhandene zweite elektrische Ausschaltmittel (6) ein, über ein Bimetall angesteuertes elektromagnetisches Relais umfasst.

7. Fehlersichere statische Umschalteinrichtung nach Anspruch 6, **dadurch gekennzeichnet, dass** das elektromagnetische Relais über ein Bimetall angesteuert wird.

8. Fehlersichere statische Umschalteinrichtung nach Anspruch 7, **dadurch gekennzeichnet, dass** das genannte Bimetall vom Hauptstrom (i) durchflossen wird und so ausgelegt ist, dass es sich verbiegt und das Relais betätigt, wenn der Hauptstrom (i) einen ersten Schwellwert überschreitet.

9. Fehlersichere statische Umschalteinrichtung nach Anspruch 7, **dadurch gekennzeichnet, dass** das genannte Bimetall von einem, über das genannte, mindestens einfach vorhandene Schmelzsicherungselement (9) fließenden Teilstrom (i/n) durchflossen wird und so ausgelegt ist, dass es sich verbiegt und das Relais betätigt, wenn der Teilstrom (i/n) einen zweiten Schwellwert überschreitet.

10. Fehlersichere statische Umschalteinrichtung nach irgendeinem der vorhergehenden Ansprüche, **dadurch gekennzeichnet, dass** alle Schmelzsicherungselemente (3) annähernd gleiche Nennstromwerte aufweisen.
